# EUROPEAN PATENT APPLICATION

(11) **EP 1 065 709 A1**
(43) Date of publication of application: **03.01.2001**
(21) Application number: 99949372.9
(22) Date of filing: 22.10.1999
(51) Int. Cl.: H01L 21/3065, H01L 21/205

(54) **SEMICONDUCTOR MANUFACTURING APPARATUS**

(30) Priority: 22.10.1998 JP 30149298
(71) Applicant: Kabushiki Kaisha Ultraclean Technology Research Institute, Bunkyo-ku, Tokyo 113-0033 (JP); Ohmi, Tadahiro, Sendai-shi, Miyagi-ken 980-0813 (JP)
(72) Inventor: OHMI, Tadahiro, Sendai-shi, Miyagi 980-0813 (JP); HIRAYAMA, Masaki, Sendai-shi, Miyagi 980-8579 (JP); NITTA, Takahisa K. K. Ultraclean Tech. Res.Inst., Bunkyo-ku, Tokyo 113-0033 (JP)
(74) Representative: Dr. Weitzel & Partner
(86) International application number: JP9905846
(87) International publication number: WO0024047

(57) **Abstract**

The present invention relates to a semiconductor manufacturing apparatus, capable of uniform processing on the substrate, occupying a small floor area for installation, and presenting a good maintainability.

The semiconductor manufacturing apparatus of the present invention, is composed of a vacuum vessel, wherein at least one substrate stage is provided on said vacuum vessel bottom plate; a cylinder is installed surrounding said substrate stage; the gap between said cylinder and said vacuum vessel top plate or bottom plate is made variable by lifting/lowering said cylinder; at least one cylinder lifting/lowering mechanism per one said cylinder is provided, in order to separate a space inside said cylinder composing a processing chamber for processing said substrate surface from a space outside said cylinder composing a transport chamber for transferring said substrate; said transport chamber is provided with a substrate conveyer mechanism for transferring said substrate between said processing chamber and said transport chamber through said gap; said processing chamber is provided with a processing chamber gas inlet and a processing chamber gas outlet; and said transport chamber is provided with a transport chamber gas inlet and a transport chamber gas outlet.

## Description

### Field of Invention

The present invention relates to a semiconductor manufacturing apparatus. More particularly, it relates to a semiconductor manufacturing apparatus, capable of an uniform processing on the substrate, occupying a small floor area for installation and presenting a good maintainability.

### Prior Art

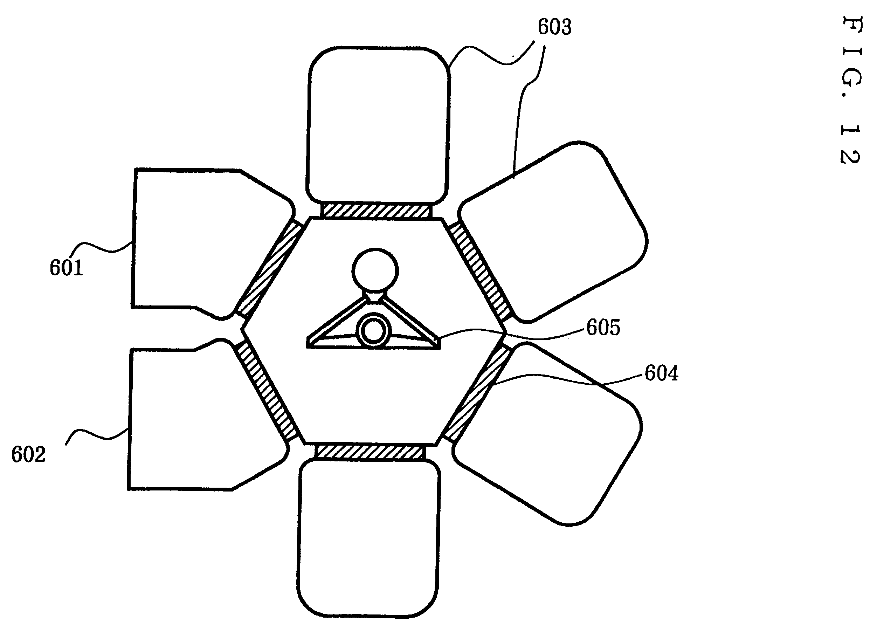

A cluster tool shown in Fig. 12 is generally used as a semiconductor manufacturing apparatus including a plurality of processing chambers and a single transport chamber.

601 designates an entrance chamber, 602 an exit chamber, 603 a processing chamber, 604 a gate valve and 605 a wafer transport robot. In this cluster tool, the processing chamber, the entrance chamber and the exit chamber are connected respectively, via the gate valve, to each side of the polygonal transport chamber provided with the wafer transport robot. All gate valves are closed and each chamber is usually vacuous in waiting condition.

Wafers are carried in and out as described below. First, a cassette containing a plurality of wafers is put in the entrance chamber from the atmosphere outside the apparatus and the entrance chamber is vacuumed. Next, the gate valve between the entrance chamber and the transport chamber opens, and the wafer transport robot takes out one of wafers in the cassette and brings it to the transport chamber by means of a transport arm. The gate valve between the processing chamber and the transport chamber is opened, and the wafer is put on a wafer stage in the processing chamber by means of the transport arm. After the processing such as plasma etching, film formation, or the like, the processed wafer is transported to the other processing chamber or to the cassette in the exit chamber.

This apparatus presents shortcomings as described below. As wafers are normally circular, it is desirable that the processing chamber inner face presents an axial symmetry structure in respect of the wafer central axis, to perform an uniform processing over the whole surface of the wafer. If the structure is not axially symmetrical, gas flow may not become uniform, or plasma may deviate if plasma is used for processing, thus jeopardizing the uniform processing. In this apparatus, as it is required to install a wafer transport opening on a side wall of the processing chamber, the inner surface of the processing chamber is not completely axially symmetrical. As the consequence, an uniform processing can not be performed over the wafer surface, thus the semiconductor production yield rate drops down.

Moreover, as the processing chamber and the transport chamber are communicated via the gate valve, the distance between the wafer transport robot and the wafer stage is long. As the consequence, a large wafer transport robot presenting a long stroke is required, and therefore, a large transport chamber is necessary. Moreover, since the gate valve is installed, the whole placing floor area of an apparatus and a cost for manufacturing the apparatus increases. As the result, a large-scale semiconductor production line is required, making difficult to reduce the initial investment cost and the production cost.

On the other hand, as an example of cluster tool occupying a small floor area for installation, a semiconductor manufacturing apparatus described in Japanese Patent Application No. 10-169213 is known. The wafer stage requires a wafer temperature control mechanism, a wafer electrostatic absorption mechanism, a high frequency impression mechanism, a wafer lift mechanism or other various complicated mechanisms. Moreover, in this cluster tool, it is necessary to install a mechanism for lifting/lowering the wafer on the lower face of the apparatus. Consequently, the maintenance becomes difficult because of the congestion on the lower face of the apparatus. Additionally, the lifting/lowering of wafer temperature control mechanism, wafer electrostatic absorption mechanism, high frequency impression mechanism, wafer lift mechanism or others with the wafer stage shortens the lifetime.

It is an object of the present invention to provide a semiconductor manufacturing apparatus, capable of uniform processing on the substrate, occupying a small floor area for installation, and presenting a good maintainability..

### Disclosure of the Invention

The semiconductor manufacturing apparatus according to the present invention, is composed of a vacuum vessel, wherein:
at least one substrate stage is provided on said vacuum vessel bottom plate;
a cylinder is installed surrounding said substrate stage;
the gap between said cylinder and said vacuum vessel top plate or bottom plate is made variable by lifting/lowering said cylinder;
at least one cylinder lifting/lowering mechanism per one said cylinder is provided, in order to separate a space inside said cylinder composing a processing chamber for processing said substrate surface from a space outside said cylinder composing a transport chamber for transferring said substrate;
said transport chamber is provided with a substrate conveyer mechanism for transferring said substrate between said processing chamber and said transport chamber through said gap;
said processing chamber is provided with a processing chamber gas inlet and a processing chamber gas outlet; and
said transport chamber is provided with a transport chamber gas inlet and a transport chamber gas outlet.

Moreover, the semiconductor manufacturing apparatus according to the present invention, is composed of a vacuum vessel, wherein:
a plurality of substrate stages are provided on said vacuum vessel bottom plate;
cylinders provided respectively with an O ring are connected to said bottom plate through a bellows so as to surround said substrate stage;
the gap between said cylinder and said vacuum vessel top plate is made variable by lifting/lowering said cylinder, and at a position where said gap becomes minimum, a plurality of cylinder lifting/lowering mechanisms per one said cylinder are provided, in order to separate hermetically a space inside said cylinder for composing a processing chamber for processing said substrate surface with said O ring from a space outside said cylinder for composing a transport chamber for transferring said substrate;
said transport chamber is provided with a substrate conveyer mechanism for transferring said substrate between said processing chamber and said transport chamber through said gap;
said processing chamber is provided with a processing chamber gas inlet and a processing chamber gas outlet; and
said transport chamber is provided with a transport chamber gas inlet and a transport chamber gas outlet.

### Brief Description of the Drawings

Fig. 1 is a schematic cross-section showing an example of a semiconductor manufacturing apparatus according to the present invention;
Fig. 2 is a cross-section along B-O-B' of the semiconductor manufacturing apparatus shown in Fig. 1;
Fig. 3 is a cross-section along C-O of the semiconductor manufacturing apparatus shown in Fig. 1;
Fig. 4 is a schematic cross-section showing an example of a semiconductor manufacturing apparatus according to the present invention;
Fig. 5 is a cross-section along B-O-B' of the semiconductor manufacturing apparatus shown in Fig. 4;
Fig. 6 is a schematic cross-section showing an example of a semiconductor manufacturing apparatus according to the present invention;
Fig. 7 is a schematic cross-section showing an example of a semiconductor manufacturing apparatus according to the present invention;
Fig. 8 is a cross-section along B-O-B' of the semiconductor manufacturing apparatus shown in Fig. 7;
Fig. 9 is a schematic cross-section showing an example of a semiconductor manufacturing apparatus according to the present invention;
Fig. 10 is a cross-section along B-O-B' of the semiconductor manufacturing apparatus shown in Fig. 9;
Fig. 11 is a cross-section along C-O of the semiconductor manufacturing apparatus shown in Fig. 9; and
Fig. 12 is a schematic view of a conventional semiconductor manufacturing apparatus.

### (Description of Symbols)

- 101: Vacuum vessel
- 102: Vacuum vessel bottom plate
- 103: Vacuum vessel top plate
- 104: Wafer
- 105: Wafer stage
- 106: Bellows
- 107: Cylinder
- 108: O-ring
- 109: Cylinder lifting/lowering mechanism
- 110: Shaft
- 111: Processing chamber
- 112: Transport chamber
- 113: Substrate conveyer mechanism
- 114: Shower plate
- 115: Processing chamber gas inlet
- 116: Processing chamber gas outlet
- 117: Processing chamber exhaust pump
- 118: Conductance adjust valve
- 119: Transport chamber gas outlet
- 120: Transport chamber exhaust pump
- 121: Cover
- 122: Inlet chamber
- 123: Outlet chamber
- 201: Part including processing chamber
- 202: Part including substrate conveyer mechanism
- 301: Radial line slot antenna
- 302: Dielectric plate
- 303: Shower plate
- 304: Coaxial wave guide
- 401: Permanent magnet
- 402: Wafer
- 403: Electrode
- 404: High frequency power source
- 501: Superior permanent magnet
- 502: Lower permanent magnet
- 503: Lower permanent magnet in the transport chamber

### Best Embodiment for Realizing the Invention

Now, embodiments of the present invention will be described referring to drawings.

### (Embodiment 1)

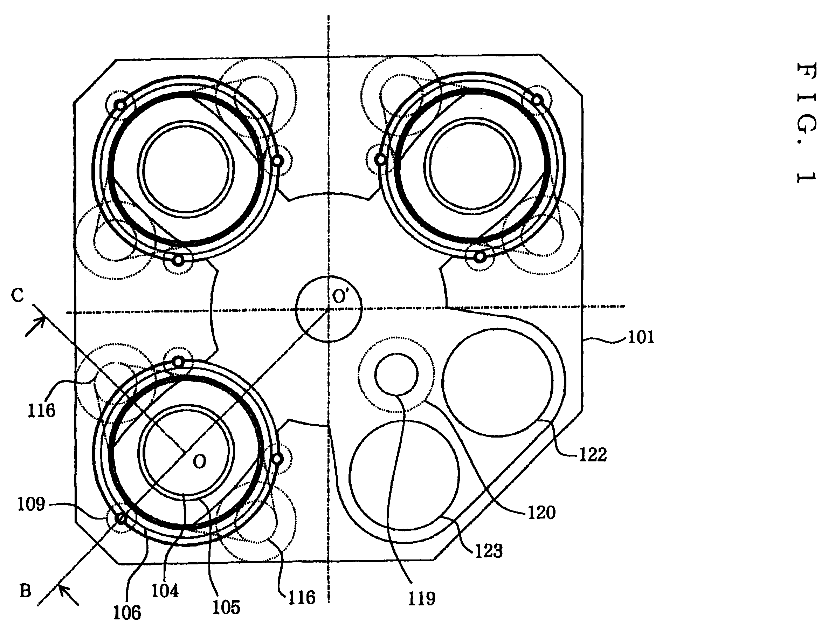

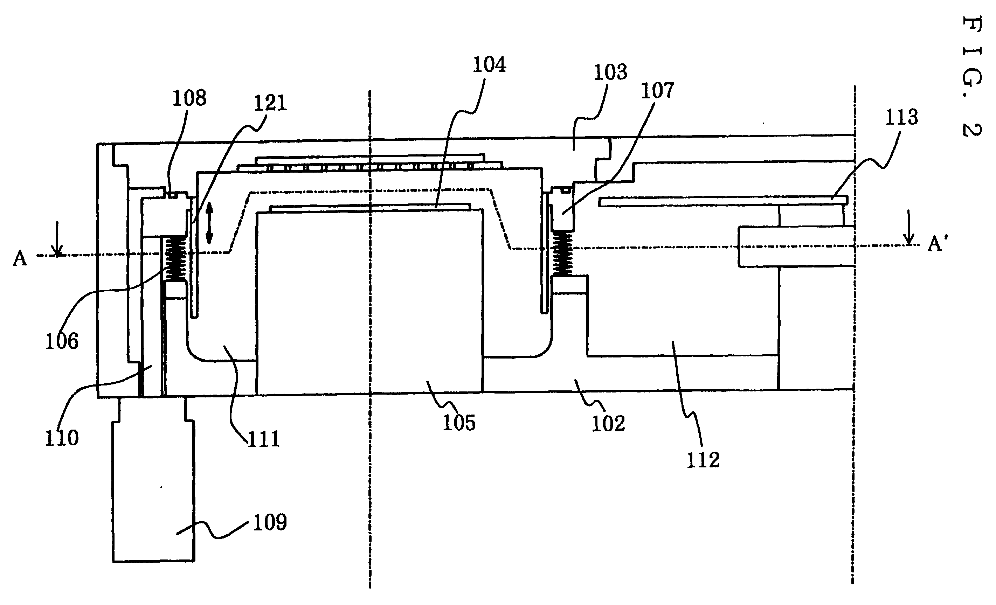

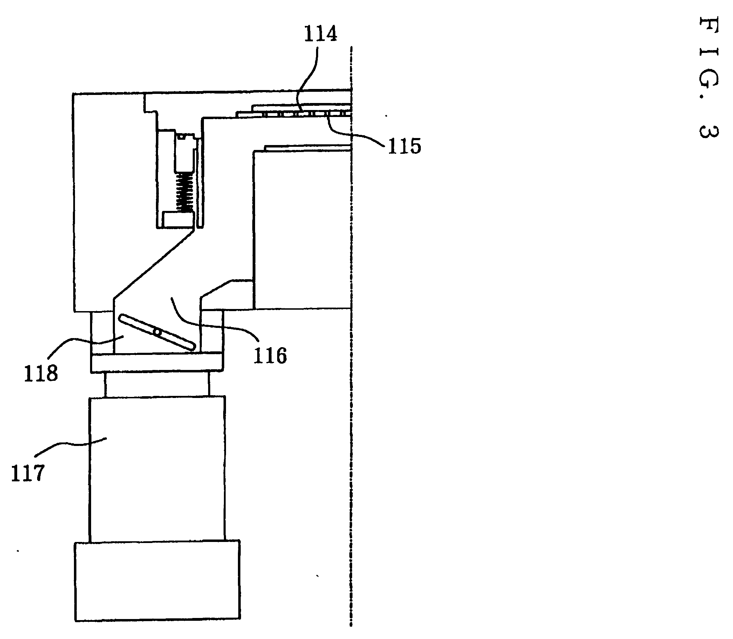

Fig. 1 to Fig. 3 are schematic cross-section views showing an example of the semiconductor manufacturing apparatus according to the present invention. Fig. 1 shows the section A-A' of Fig. 2, Fig. 2 the section B-O-O' of Fig. 1, and Fig. 3 the section C-O of Fig. 1. In Fig. 1, 101 designates Vacuum vessel, 102 Vacuum vessel bottom plate, 103 Vacuum vessel top plate, 104 Wafer, 105 Wafer stage, 106 Bellows, 107 Cylinder, 108 O-ring, 109 Cylinder lifting/lowering mechanism, 110 Shaft, 111 Processing chamber, 112 Transport chamber, 113 Substrate conveyer mechanism, 114 Shower plate, 115 Processing chamber gas inlet, 116 Processing chamber gas outlet, 117 Processing chamber exhaust pump, 118 Conductance adjust valve, 119 Transport chamber gas outlet, 120 Transport chamber exhaust pump, 121 Cover, 122 Inlet chamber, and 123 Outlet chamber, respectively.

The cylinder 107 can be lifted/lowered by the cylinder lifting/lowering mechanism 109. In the example of Fig. 1 to 3, three cylinder lifting/lowering mechanisms per processing chamber are installed; however their number is not restricted to three. During stand-by and processing, the cylinder 107 comes into contact with the vacuum vessel top plate 103 as shown in Fig. 2, and the processing chamber 111 and the transport chamber 112 are isolated hermetically. During wafer transport, the cylinder 107 is lowered to make a gap between the cylinder 107 and the vacuum vessel top plate 103, and wafers are transported through this gap by the arm of the substrate conveyer mechanism 113.

During wafer processing, a desired gas is introduced into the processing chamber through a plurality of processing chamber gas inlets 115. This gas passes through a taper section from around the wafer stage 105 and is evacuated outside the processing chamber from the processing chamber gas outlet 117. At the bottom of the processing chamber, two processing chamber exhaust pumps 116 are disposed substantially at the opposite angle position to the wafer central axis via the conductance adjust valve 118, respectively. However, the number of processing chamber exhaust pump is not limited to two.

Wafers are carried in/out as the following. First a vessel containing a plurality of wafers is put in the inlet chamber 122 from the atmosphere outside the apparatus and a single wafer is taken out from the inlet chamber 122 by an arm of the substrate conveyer mechanism 113. Next, the cylinder 107 is lowered to make a gap between the cylinder 107 and the vacuum vessel top plate 103, and wafers are put on the wafer stage 105 through this gap. Moreover, the processing chamber 111 and the transport chamber 112 are isolated hermetically again by lifting the cylinder 107. Next, plasma etching, thin film deposition or other processing is applied to the wafer surface on the wafer stage 105. After the processing, the cylinder 107 is lowered again by the cylinder lifting/lowering mechanism 109 to make a gap between the cylinder 107 and the vacuum vessel top plate 103, then processed wafers are taken out by the arm.

In this apparatus, as the processing chamber inner surface is completely axially symmetrical in respect of the wafer central axis, an uniform processing can be applied over the whole wafer surface. Moreover, as the gate valve is not used, the whole apparatus shall occupy a very small floor area. For instance, the floor occupation space of a cluster tool corresponding to a wafer of 200 mm in diameter will be about 1/3 of the conventional cluster tool. In addition, as the mechanism for lifting/lowering the wafer stage is not required, a large vacant space is ensured over the apparatus bottom face, assuring a good maintainability.

In the examples of Fig. 1 to Fig. 3, three processing chambers, one inlet chamber and one outlet chamber are clustered; but the number of respective chambers is not limited to them.

### (Embodiment 2)

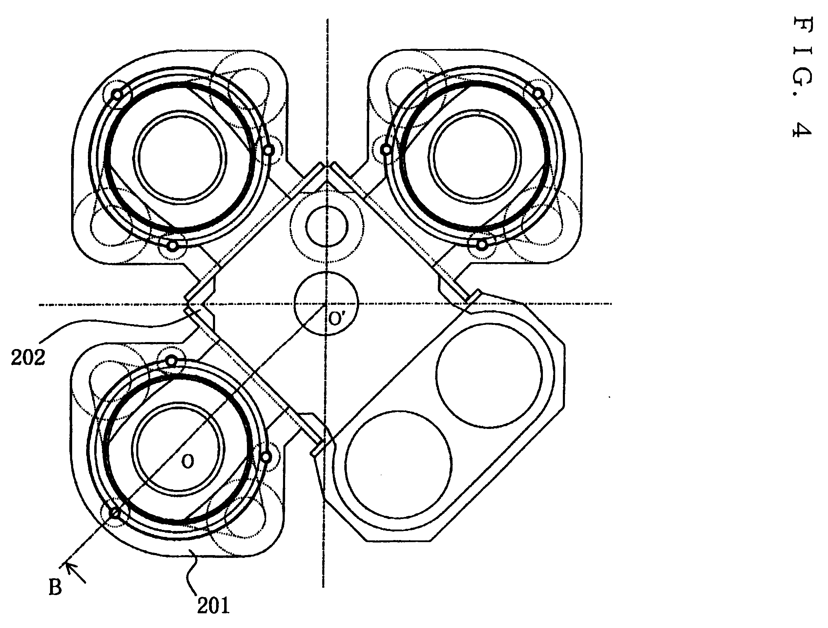

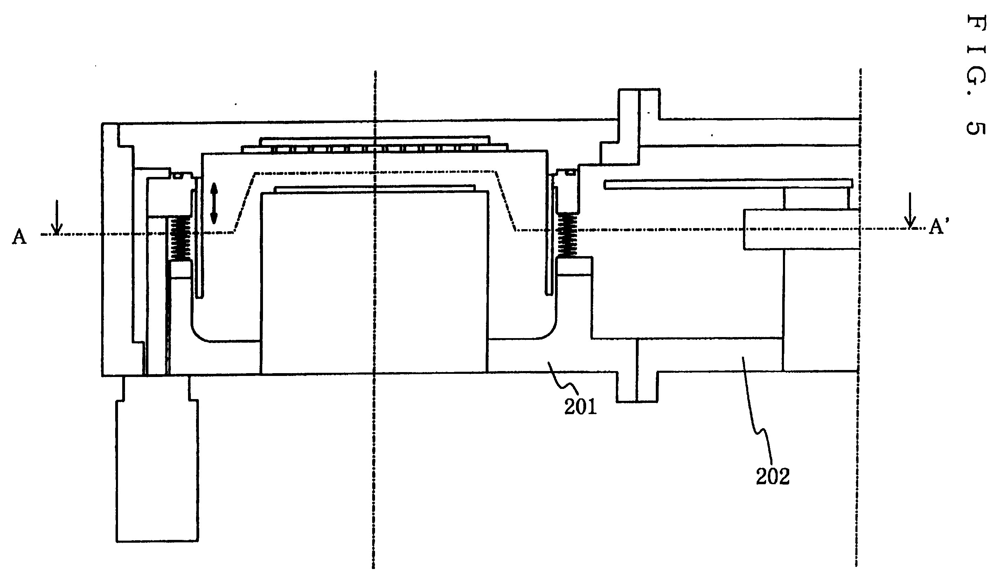

Fig. 4 and Fig. 5 are schematic cross-sections showing an example of the semiconductor manufacturing apparatus according to the present invention. Fig. 4 shows the section A-A' of Fig. 5 and Fig. 5 the section B-O-O' of Fig. 4. This example is similar to the one of Fig. 1 to Fig. 3, except that the vacuum vessel can be divided into a part 201 including the processing chamber and a part 202 including the substrate conveyer mechanism. As the processing chamber can be maintained separating from the cluster tool, its maintainability is better than the cases of Fig. 1 to Fig. 3.

### (Embodiment 3)

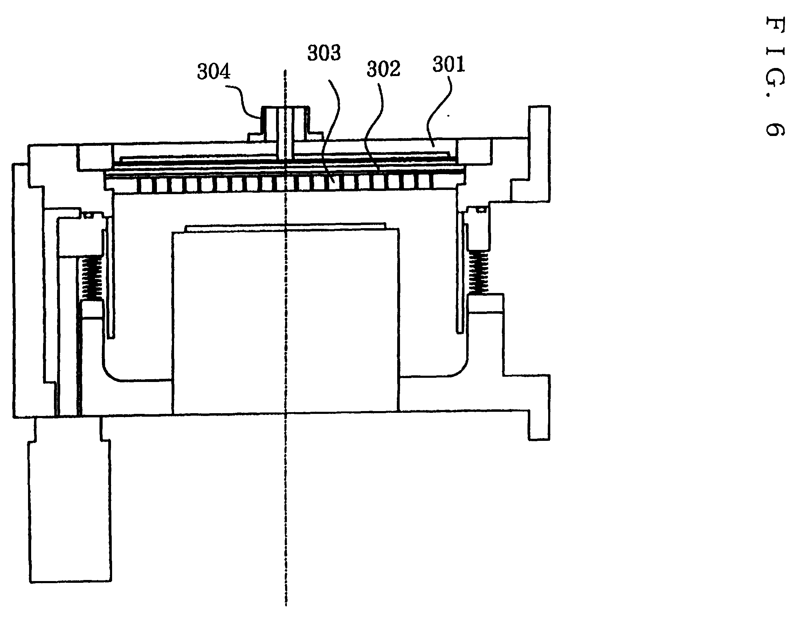

Fig. 6 is a schematic cross-section view showing an example of the semiconductor manufacturing apparatus according to the present invention. In the vacuum vessel, only a portion including the processing chamber is shown. 301 designates radial line slot antenna, 302 dielectric plate, 303 shower plate, and 304 coaxial wave guide. In the structure of Fig. 4 and Fig. 5, a plasma exciting mechanism is provided on the top of the processing chamber of the apparatus. The other parts are similar to Fig. 4 and Fig. 5.

The shower plate 303 is composed of dielectric material. The radial slot line antenna 301 is supplied with microwave from the coaxial wave-guide 304. Microwave radiated from the radial line slot antenna 301 is introduced into the processing chamber through the dielectric plate 302 and the shower plate 303, and this micro wave creates plasma in the processing chamber. In the processing chamber, plasma etching, resist ashing, plasma CVD (chemical vapor deposition) or other processing can be performed on the wafer.

### (Embodiment 4)

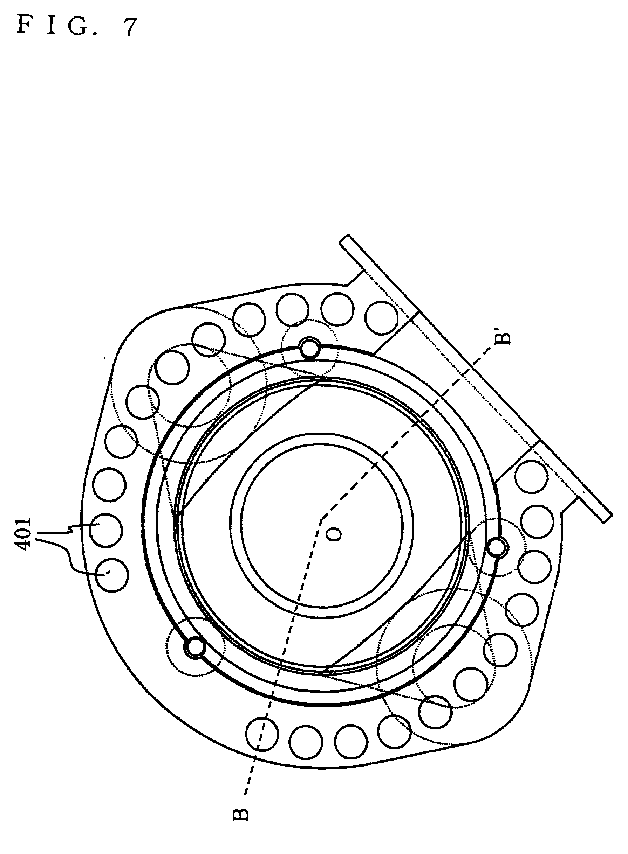

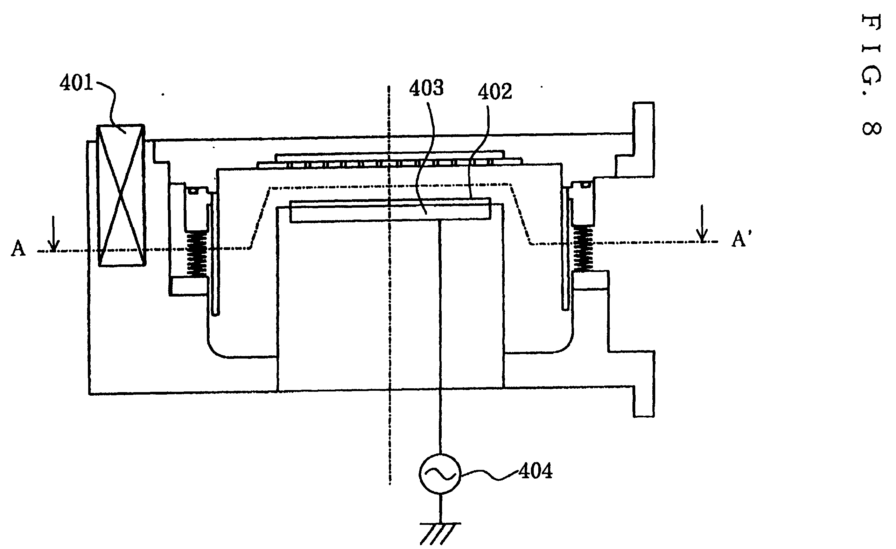

Fig. 7 and Fig. 8 are schematic cross-section views showing an example of the semiconductor manufacturing apparatus according to the present invention. Fig. 7 shows the section A-A' of Fig. 8 and Fig. 8 the section B-O-B' of Fig. 7. In the vacuum vessel, only a part including the processing chamber is shown. 401 designates permanent magnet, 402 wafer, 403 electrode and 404 high frequency power source. The other portions are similar to the example of Fig. 4 and Fig. 5. In this example, permanent magnet is not disposed near the wafer transport path and near its opposite angle portion. However, a permanent magnet may be disposed near the opposite angle portion near the wafer transport path.

A plurality of permanent magnets 401 is disposed substantially on the circumference, in order to impress magnetic field around the wafer. High frequency impression to the electrode 403 by the high frequency source 404 generates plasma in the processing chamber. Magnetic filed impression improves the plasma generation efficiency to enable to generate a high-density plasma. For instance, 13.56 MHz is adopted as high frequency and 120 Gauss as magnetic flux density around the wafer. In the processing chamber, plasma etching, resist ashing, plasma CVD (chemical vapor deposition), sputter film deposition or other processing can be performed on the wafer.

### (Embodiment 5)

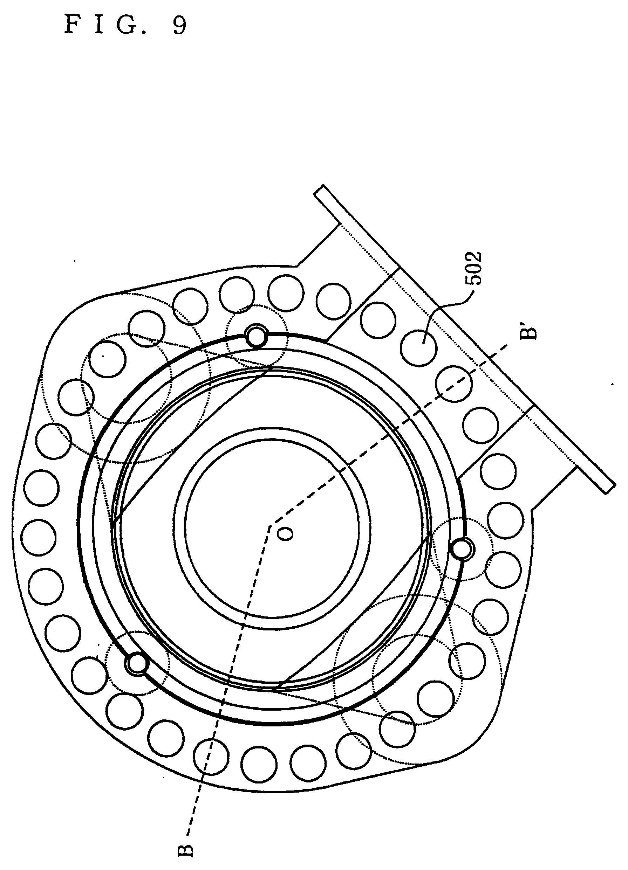

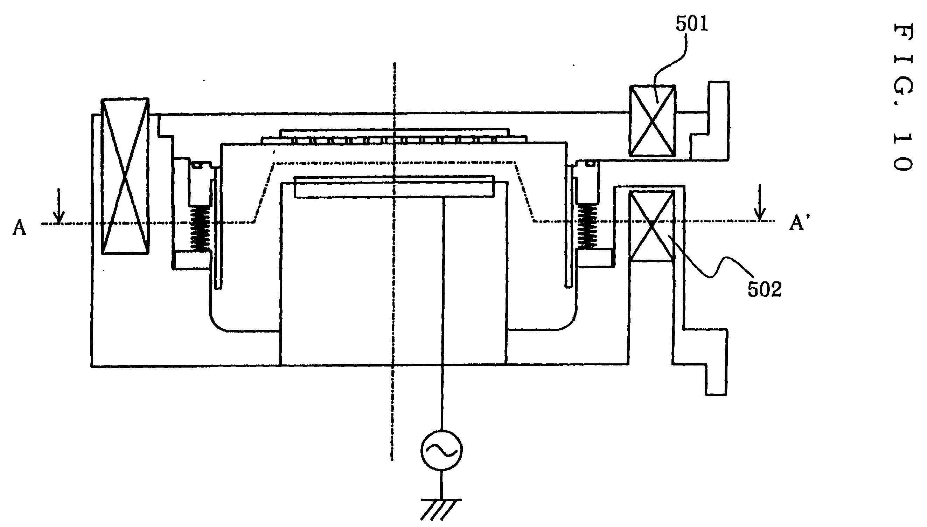

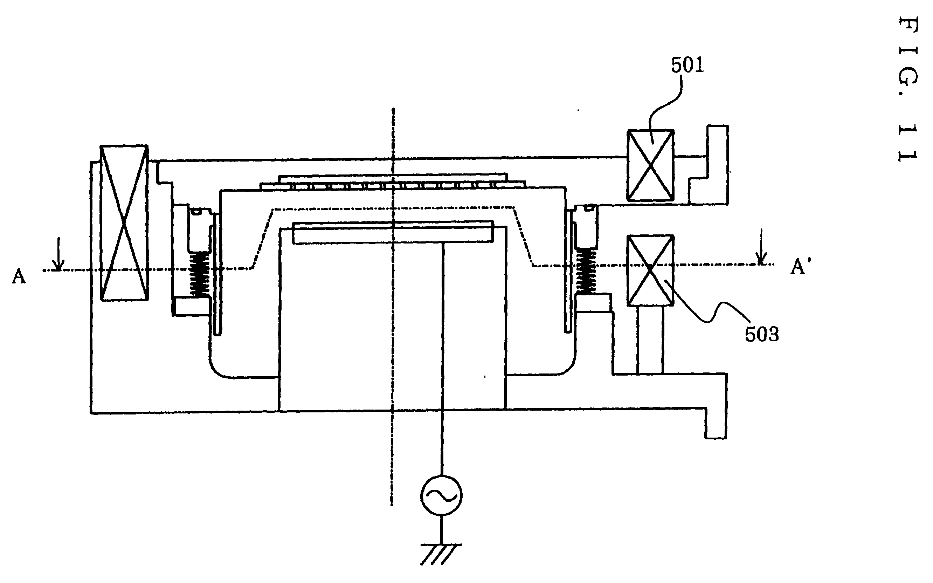

Fig. 9 to Fig. 11 are schematic cross-section views showing an example of the semiconductor manufacturing apparatus according to the present invention. Fig. 9 shows the section A-A' of Fig. 10 or Fig. 11 and Fig. 10 or Fig. 11 the section B-O-B' of Fig. 9. In the vacuum vessel, only a part including the processing chamber is shown. 501 designates upper permanent magnet, 502 lower permanent magnet, and 503 lower permanent magnet in the transport chamber. In this example, permanent magnets are disposed near the wafer transport path and also near its opposite angle portion. The other portions are similar to the example of Fig. 7 and Fig. 8. Respective permanent magnets 501, 502 and 503 are disposed in the position not interfering with the wafer transport. In the example of Fig. 10, the lower permanent magnet 502 is installed in the atmosphere, while, in the example of Fig. 11, the lower permanent magnet 503 is installed in the transport chamber. As permanent magnets are installed also near the wafer transport path, it is possible to impress a magnetic field of higher uniformity than Fig. 7 and Fig. 8 around the wafer. Therefore, it is possible to generate plasma having higher uniformity, as the result, enabling to apply a more uniform processing to the wafer.

### Industrial Application

The present invention can provide a semiconductor manufacturing apparatus, capable of uniform processing on the substrate, occupying a small floor area for installation, and presenting a good maintainability.

## Claims

1. A semiconductor manufacturing apparatus, composed of a vacuum vessel; wherein,
at least one substrate stage is provided on said vacuum vessel bottom plate;
a cylinder is installed surrounding said substrate stage;
the gap between said cylinder and said vacuum vessel top plate or bottom plate is made variable by lifting/lowering said cylinder;
at least one cylinder lifting/lowering mechanism per one said cylinder is provided, in order to separate a space inside said cylinder composing a processing chamber for processing said substrate surface from a space outside said cylinder composing a transport chamber for transferring said substrate;
said transport chamber is provided with a substrate conveyer mechanism for transferring said substrate between said processing chamber and said transport chamber through said gap;
said processing chamber is provided with a processing chamber gas inlet and a processing chamber gas outlet; and
said transport chamber is provided with a transport chamber gas inlet and a transport chamber gas outlet.

2. A semiconductor manufacturing apparatus, composed of a vacuum vessel; wherein,
a plurality of substrate stages are provided on said vacuum vessel bottom plate;
cylinders provided respectively with an O ring are connected to said bottom plate through a bellows so as to surround said substrate stage;
the gap between said cylinder and said vacuum vessel top plate is made variable by lifting/lowering said cylinder, and at a position where said gap becomes minimum, a plurality of cylinder lifting/lowering mechanisms per one said cylinder are provided, in order to separate hermetically a space inside said cylinder for composing a processing chamber for processing said substrate surface with said O ring from a space outside said cylinder for composing a transport chamber for transferring said substrate;
said transport chamber is provided with a substrate conveyer mechanism for transferring said substrate between said processing chamber and said transport chamber through said gap;
said processing chamber is provided with a processing chamber gas inlet and a processing chamber gas outlet; and
said transport chamber is provided with a transport chamber gas inlet and a transport chamber gas outlet.

3. The semiconductor manufacturing apparatus according to claim 1 or 2, wherein said vacuum vessel can be divided into a part including said processing chamber and a part having said substrate transport mechanism.

4. The semiconductor manufacturing apparatus according to claim 1 and claim 3 comprising a plasma generation mechanism for generating plasma in said processing chamber.

5. The semiconductor manufacturing apparatus according to claim 4, wherein said plasma generation mechanism radiates microwave thorough a slot antenna.

6. The semiconductor manufacturing apparatus according to claim 4, wherein a plurality of cylindrical permanent magnets are disposed substantially on the circumference surrounding the substrate in the atmosphere outside said vacuum vessel, in order to impress magnetic field around said substrate.

7. The semiconductor manufacturing apparatus according to any one of claims 1 to 6, wherein said substrate stage is provided with a means for impressing direct current or alternating current power.
